**Europäisches Patentamt**

**European Patent Office**

**Office européen des brevets**

(19)

(11) Publication number : **0 407 044 B1**

(12) # EUROPEAN PATENT SPECIFICATION

(45) Date of publication of patent specification :
**02.03.94 Bulletin 94/09**

(51) Int. Cl.⁵ : **H01L 21/00**

(21) Application number : **90306455.8**

(22) Date of filing : **13.06.90**

(54) **A shutter system.**

(30) Priority : **13.06.89 JP 68063/89**

(43) Date of publication of application :
**09.01.91 Bulletin 91/02**

(45) Publication of the grant of the patent :
**02.03.94 Bulletin 94/09**

(84) Designated Contracting States :
**DE FR GB**

(56) References cited :
**WO-A-87/06862**
**US-A- 4 418 646**
**US-A- 4 715 764**
**US-A- 4 746 397**

(73) Proprietor : **SHIN-ETSU HANDOTAI COMPANY LIMITED**
**4-2, Marunouchi 1-Chome**
**Chiyoda-ku Tokyo (JP)**

(72) Inventor : **Kudo, Hideo**
**89-2 Aza-haranka, Ooaza-odakura,**
**Nishigo-mura**
**Nishi-shirakawa-gun, Fukushima-ken (JP)**

(74) Representative : **Whalley, Kevin et al**
**MARKS & CLERK 57/60 Lincoln's Inn Fields**
**London WC2A 3LS (GB)**

EP 0 407 044 B1

Description

The present invention relates to a shutter system adapted to open and close a communication between two rooms.

For example, at a semiconductor wafer washing process in a semiconductor wafer manufacturing line, the process requires a semiconductor wafer to be transported from a container containing pure water to a container containing a cleaning solution, and vice versa. In these transportation operations, an opening made in a partition wall separating the two containers is opened and closed by means of a shutter device. When the semiconductor wafer is transported, the opening is opened, and when the transportation is completed, the opening is closed.

Ideally speaking, when the semiconductor wafer is passed through the unshuttered opening in the partition wall, from one room (container) to the other, no liquid should flow into the next room. If pure water flows into the room containing the cleaning solution via the opening, the cleaning solution is diluted and loses its cleaning strength. In order to prevent such flow of liquid, the levels of the liquids in the adjoining rooms are adjusted such that the respective pressures of the liquids at the opening are approximately equal to each other. In particular, if the specific gravity of the cleaning solution is greater than the specific gravity of the pure water, the level of the pure water is set higher than the level of the cleaning solution.

Also, the turbulence of the liquids caused by such flow of the liquids surrounding the semiconductor wafer being transported, makes it difficult to achieve high quality surface of the semiconductor wafer.

However, with the conventional shutter systems, the movement of the valve of the shutter device and other elements through the fluid invariably creates intermixing through flow and turbulence of the fluid, thus degrading the surface quality of the wafer.

The present invention was contrived in view of the above problems, and, therefore, it is an object of the invention to provide a shutter system capable of opening and closing a communication passage between two rooms without causing intermixing through turbulence as well as through flow of the liquids.

In order to achieve the above object and others, the present invention proposes a shutter system having two rooms containing liquids, a partition wall provided between the two rooms, a shutter device for opening and closing an opening made in the partition wall, the opening having a brim with a flush ridge, characterized by that the shutter device comprises a frame body and a valve sheet made of a thin film which is held by the frame body in parallel to the flush ridge of the brim of the opening and adapted to shift across and in parallel to the flush ridge, a press means adapted to press the valve sheet onto the flush ridge of the brim of the opening, a first drive means for driving the valve sheet to shift across and in parallel to the flush ridge, and a second drive means for driving the press means to move toward the brim of the opening in the partition wall.

Preferably, the press means consists of a lever adapted to turn about a fulcrum shaft and a drive mechanism for turning the lever.

More preferably, the opening has a brim with a flush ridge line which is in parallel to the partition wall.

According to the invention, since the valve sheet has a small thickness and is held in parallel to the partition wall, when it shifts through a fluid in parallel to the partition wall on its way to shuttering or unshuttering the opening in the partition wall, the fluid resistance is so scarce that almost no flow or turbulence of the fluid is caused around the valve sheet.

Incidentally, the present invention has a prerequisite in its application that the pressures of the liquids at the opening in the partition wall are made approximately equal to each other, so that no flow of liquids takes place between the two rooms when the opening is opened, and that no deformation of the filmy valve sheet occurs when the opening is closed with the valve sheet. Thus, if this prerequisite is observed, the valve sheet performs reliably and is not damaged even though it is made of a soft film.

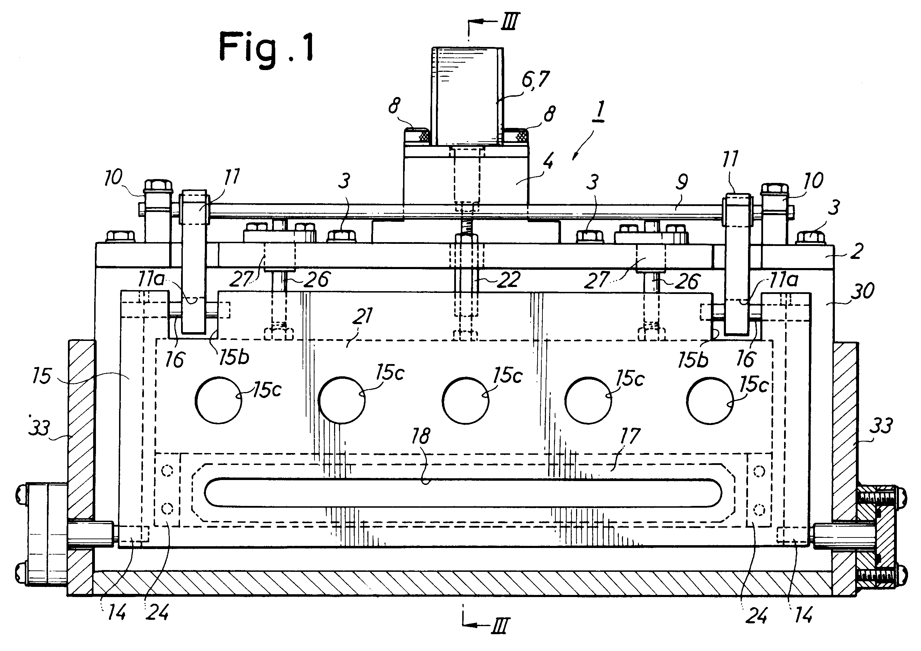

Fig. 1 is a partial cross-sectional front view of a shutter device of the present invention;

Fig. 2 is a plan view of the same shutter device;

Fig. 3 is a cross-sectional view taken on line III-III of Fig. 1 showing a shutter system of the invention;

Fig. 4 is a view similar to Fig. 3 wherein the shutter device is assuming an open posture;

Fig. 5 is an exploded view in perspective of the same shutter device; and

Fig. 6 is a diagram useful for an explanation of the distribution of the pressure on a valve sheet of the same shutter device.

An embodiment of the invention will be described with reference to the attached drawings.

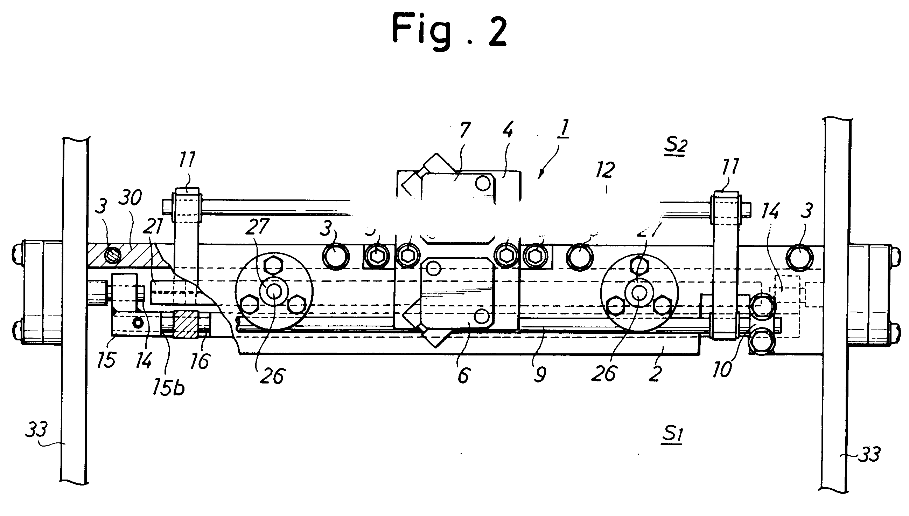

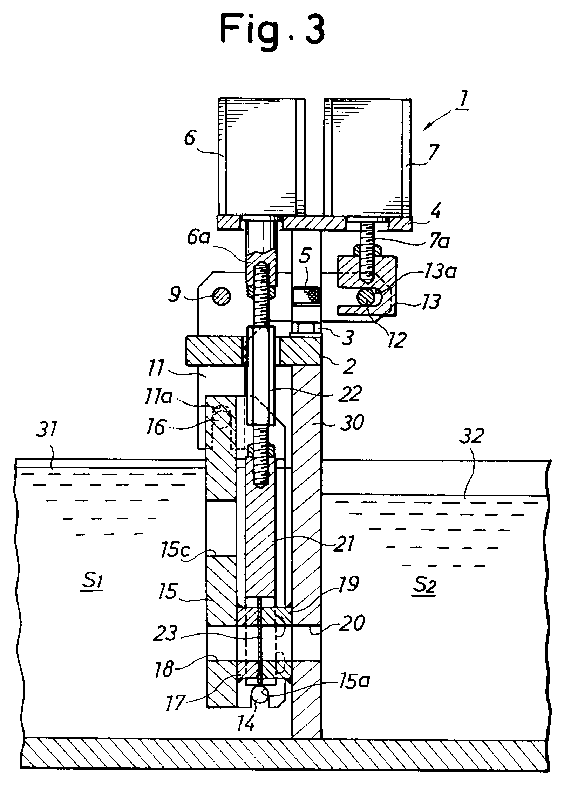

In Fig. 2 and Fig. 3, reference numerals $S_1$ and $S_2$ designate containers partitioned from each other by a vertically standing partition wall 30, of which $S_1$ contains pure water 31 and $S_2$ contains cleaning solution 32. Incidentally, the specific gravity $\gamma_2$ of the cleaning solution 32 is greater than that $\gamma_1$ (=1,000 kg/ m³) of the pure water 31, that is $\gamma_2 > \gamma_1$.

A shutter device 1 according to the invention is provided on the partition wall 30, and a horizontal base plate 2 of the shutter device 1 is fixed on top of the partition wall 30 by means of bolts 3, 3. A support platform 4 is fixed on the middle portion of the base plate 2 by means of bolts 5, 5. Two vertical air cylinders 6 and 7 are fixed on the support platform 4 by means of bolts 8, 8.

Over the base plate 2, a lengthy round shaft 9 is provided to extend horizontally in the direction of the width of the base plate 2 (i.e., vertical to the plane of the sheet of Fig. 3) and is supported at its ends by bearings 10, 10 in a manner such that the shaft 9 can turn about its axis. L-shaped levers 11, 11 (Fig. 3) are fixed about the end portions (but inner than the bearings 10) of the shaft 9 which penetrates through the levers 11, 11 at their bent portion. A round rod 12 extending in parallel to the shaft 9 has its ends fixedly received in that ends of the L-shaped levers 11, 11 which are roughly level with the bent portions of the levers 11, 11. A support block 13 having a horizontal recess 13a is connected to the lower end of a reciprocation rod 7a extending from the air cylinder 7, and the recess 13a is engaged with the center portion of the shaft 12, as shown in Fig. 3.

A pair of coaxial horizontal pins 14, 14 are provided to extend inwardly from the lower part of side walls 33, 33 of the container $S_1$ and are engaged with respective recesses 15a made in the lower corners of the press body 15. This press body 15 is capable of tilting about the pins 14, and has a pair of cutout indents 15b, 15b in the vicinity of its upper corners. A round horizontal pin 16 is provided across each of the indents 15, in a manner such that they are coaxial to each other and in parallel to the shaft 9. The pins 16 are engaged with respective recesses 11a made in the lower end of the levers 11. At about the middle height of the press body 15 are formed five circular bores 15c in a horizontal row at regular intervals. On the lower part of that face of the press body 15 which opposes the partition wall 30 is welded a lengthy press piece 17, which extends widthwise of the press body 15. A lengthy horizontal slit opening 18, extending widthwise of the press body 15, is formed to penetrate through the press body 15 and the press piece 17.

On the lower part of that face of the partition wall 30 which is on the side of the container $S_1$, is welded a lengthy slitted seat piece 19 having substantially the same shape and size as the press piece 17, in a manner such that the slit of the press piece 17 aligns with the slit of the seat piece 19. Also, a slit opening 20 is formed in the partition wall 30 in a manner such that the slit opening 18 and the slit opening 20 form a single penetrating slit through the press body 15, the press piece 17, the seat piece 19, and the partition wall 30.

A rectangular shutter body 21 in the form of a plate is provided between the press body 15 and the partition wall 30. The shutter body 21 is capable of shifting vertically. The shutter body 21 is connected to, and supported by, a reciprocation rod 6a extending from the air cylinder 6 via a turn buckle 22 which is partially embedded in the middle portion of the top of the shutter body 21. The turn buckle can be turned to thereby arbitrarily adjust the altitudinal position of the shutter body 21.

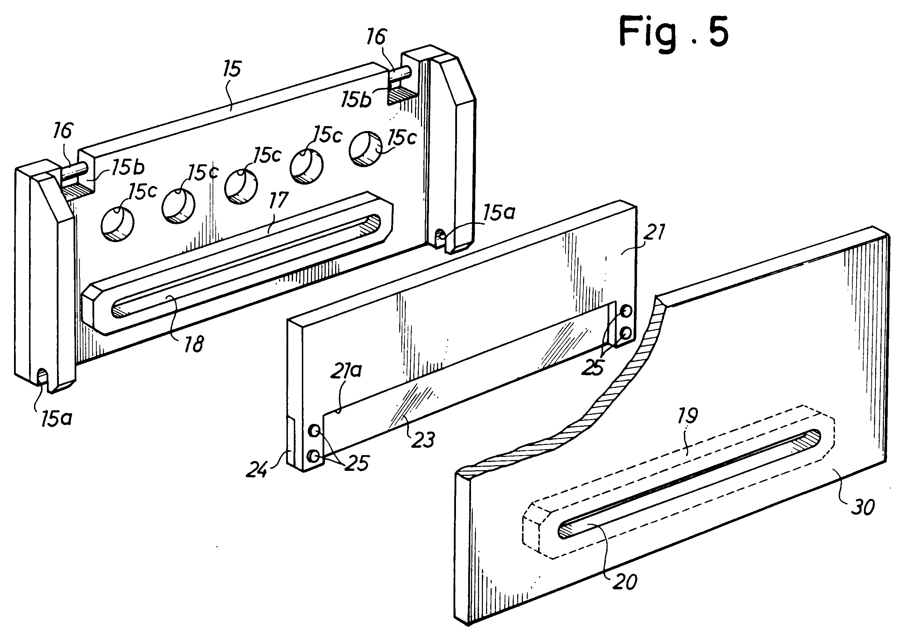

As shown in Fig. 5, a lengthy rectangular cutout indent 21a is formed in the lower edge of the shutter body 21 extending widthwise thereof, and a thin film of valve sheet 23 made of polyether-ether ketone (PEEK) is spread across the indent 21a. The left and right ends of the valve sheet 23 are fitted between the shutter body 21 and the respective stoppers 24, 24 which are pressed onto the recessed lower corners of the shutter body 21 by means of bolts 25. A pair of vertical guide shafts 26, 26 are connected to the top edge of the shutter body 21, and are slidably inserted in guide bushes 27, 27 which are provided in the base plate 2.

Next, the operation of the shutter device 1 will be explained.

Fig. 3 shows a circumstance in which the communication between the container $S_1$ and the container $S_2$ is interrupted by the shutter device. In this circumstance, the shutter body 21 assumes a lower position, as shown, and the valve sheet 23 stretched in the shutter body 21 seats itself on the slitted seat piece 19 to thereby close the slit opening 20 formed through the seat piece 19 and the partition wall 30.

Incidentally, the valve sheet 23 is pressed onto the borders of the slit opening 20 of the seat piece 19 by means of the press piece 17 so that the opening 20 is completely closed by the valve sheet 23.

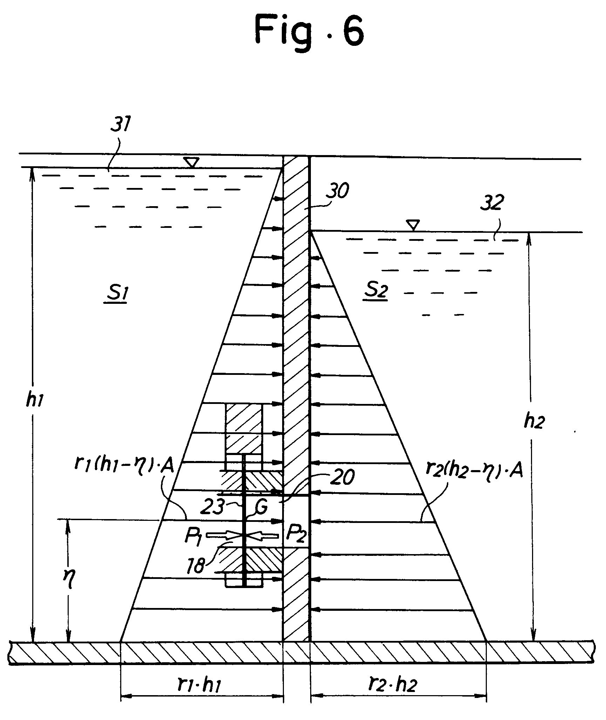

The level $h_1$ of the pure water contained in the container $S_1$ and the level $h_2$ of the cleaning solution 32 contained in the container $S_2$ are controlled to levels such that the liquid pressures acting on either side of the valve sheet 23, which assumes a closing position in Fig. 3, are substantially identical. The distribution of the pressures of the pure water 31 and the cleaning solution 32 to which the partition wall 30 and the valve sheet 23 are subjected is shown in Fig. 6. The pure water 31 and the cleaning solution 32 press themselves on the valve sheet 23 by way of the openings 18 and 20, respectively.

Let the force (total pressure) of the pure water 31 to which the valve sheet 23 is subjected be $P_1$, and similarly let the force (total pressure) of the cleaning solution 32 be $P_2$; also let the opening area of the openings 18, 20 be A; and let the height of the center of gravity G of the valve sheet 23 be $\eta$; then, the forces $P_1$ and $P_2$ are given by the following equations (1) and (2), respectively.

$$P_1 = \gamma_1 (h_1 - \eta) \cdot A \quad (1)$$
$$P_2 = \gamma_2 (H_2 - \eta) \cdot A \quad (2)$$

As described above, the forces $P_1$ and $P_2$ are controlled to be approximately identical, and to do so the following approximation (3) ought to hold:

$$\frac{h_1 - \eta}{h_2 - \eta} \doteqdot \frac{\gamma_2}{\gamma_1} \quad (3)$$

Hence, the level $h_1$ of the pure water 31 and the level $h_2$ of the cleaning solution 32 are set to values such that the approximation (3) is satisfied. In reality, if the specific gravity $\gamma_2$ of the cleaning solution 32 is greater than the specific gravity $\gamma_1$ of the pure water 31 ($\gamma_2 > \gamma_1$), the level $h_1$ of the pure water 31 is set greater than the level $h_2$ of the cleaning solution 32, as shown in Fig. 6.

Incidentally, the point of application, or the pressure cone apex, of the forces $P_1$ and $P_2$ comes, in reality, somewhat lower than the center of gravity G.

Thus, when the shutter device 1 assumes the closing posture, the thin film valve sheet 23 is acted upon by the mutually balancing forces $P_1$ and $P_2$ of approximately identical magnitudes, so that the valve sheet 23 is not deformed or damaged even though it is thin and soft. As a result, the valve sheet 23 performs reliably as the shutter means.

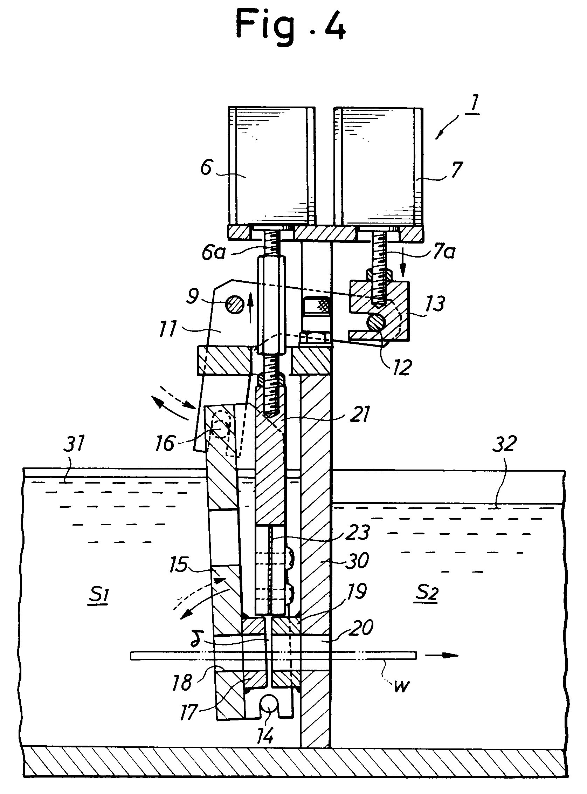

Next, how the opening 20 is unshuttered will be described. First, the air cylinder 7 is driven to force the rod 7a to shift downward. As the rod 7a thus descends, the lever 11 turns clockwise about the shaft 9, as shown in Fig. 4, whereby the press body 15 is tilted counterclockwise about the pins 14, as shown in Fig. 4. As a result, a gap $\delta$ is created between the press piece 17 on the press body 15 and the seat piece 19 on the partition wall 30, as shown.

Thereafter, the other air cylinder 6 is driven to force the rod 6a to shift upward, whereby the shutter body 21 is raised, and the valve sheet 23 attached to the shutter body 21 slips upward through the gap $\delta$ between the press piece 17 and the seat piece 19 whereupon the slit opening 20 is unshuttered. As a result, the containers $S_1$ and $S_2$ are put into communication with each other via the slit opening 20, and a semiconductor wafer W immersed in the pure water 31 in the container $S_1$, is transported past the slit opening 18, 20 to the container $S_2$ and washed with the cleaning solution 32 in the container $S_2$.

When the transportation of the semiconductor wafer W is completed, the air cylinder 6 is driven to force the rod 6a to shift downward to thereby bring down the shutter body 20 together with the valve sheet 23, which slips into the gap $\delta$ between the press piece 17 and the seat piece 19, shown in, Fig. 4. Thereafter, the other air cylinder 7 is driven to force the rod 7a to shift upward to thereby cause the lever 11 to turn about the shaft 9 counterclockwise, and as a result the press body 15 together with the press piece 17 provided on the press body 15 turns clockwise about the pins 14 to thereby urge the valve sheet 23 onto the borders of the slit opening 20 of the seat piece 19 whereupon the slit opening 20 is completely shuttered with the valve sheet 23, and the communication between the containers $S_1$ and $S_2$ is disrupted.

As described above, opening and closing of the slit opening 20 is effected by vertical shifting of the valve sheet 23; and since the valve sheet 23 is very thin in thickness, its vertical movement does not create turbulence in the surrounding liquids so that the surface quality of the semiconductor wafers is maintained high.

Also, as described above, since the pressure of the pure water 31 and that of the cleaning solution at the opening 20 are approximately equal, even when the opening 20 is unshuttered, as shown in Fig. 4, no substantial flow of a liquid takes place from the container $S_1$ to the container $S_2$ or vice versa. Therefore, neither liquid is diluted with the other; for example, the cleaning solution 32 is not diluted with the pure water 31.

Incidentally, in the above embodiment, the invention is applied to a washing apparatus in the field of semiconductor wafer manufacturing, it is possible to apply the same invention to any apparatus of any field wherein two different liquids come in contact with each other, so long as an arrangement is made to equilibrate the liquid pressures at the interface.

It should be understood that the foregoing relates to only a preferred embodiment of the invention.

**Claims**

1. A shutter system having two rooms ($S_1$, $S_2$) containing liquids (31, 32), a partition wall (30) provided between the two rooms, a shutter device for opening and closing an opening (20) made in said partition wall, said opening having a brim means (19) with a flush ridge, characterized by that said shutter device comprises a frame body (21) and a valve sheet (23) made of a thin film which is held by said frame body in parallel to said flush ridge of the brim means of said opening and adapted to shift across and in parallel to said flush ridge, a press means (15) adapted to press the valve sheet onto the flush ridge of the brim means of said opening, a first drive means (6, 22) for driving the valve sheet to shift across and in parallel to said flush ridge, and a second drive means (7, 11) for driving the press means to move toward the brim means of said opening in said partition wall.

2. A shutter system of claim 1, wherein the static pressures of the liquids contained in the respective rooms are controlled to be nearly equal to each other at the depth of said opening made in said partition wall.

3. A shutter system of claim 1, wherein said press means consists of a lever (15) adapted to turn about a fulcrum shaft (14) and a drive mechanism (7, 13, 12, 11, 16) for turning said lever.

4. A shutter system of claim 1, wherein said brim means of said opening has a flush ridge which is in parallel to the partition wall.

5. A shutter system of claim 1 used for washing semiconductor wafers, wherein said opening has an appropriate dimension as a passage for a semiconductor wafer.

6. A shutter system of claim 1, wherein said valve sheet of the shutter device is made of polyether-ether ketone.


## Patentansprüche

1. Verschlußsystem mit zwei Räumen ($S_1$, $S_2$), die Flüssigkeiten (31, 32) enthalten, einer Trennwand (30), die zwischen den beiden Räumen vorhanden ist, einer Verschlußeinrichtung zum Öffnen und Schließen einer in der Trennwand vorhandenen Öffnung (20), wobei die Öffnung eine Randeinrichtung mit einer bündigen Kante (19) aufweist, **dadurch gekennzeichnet,** daß die Verschlußeinrichtung einen Rahmenkörper (21) und eine Abdichtfolie (23) umfaßt, die aus einem dünnen Film besteht und durch den Rahmenkörper parallel zu der bündigen Kante der Randeinrichtung der Öffnung gehalten wird und sich über und parallel zu der bündigen Kante bewegen kann, eine Druckeinrichtung (15), die die Abdichtfolie über an die bündige Kante der Randeinrichtung der Öffnung drückt, eine erste Antriebsrichtung (6,22), die die Abdichtfolie und parallel zu der bündigen Kante verschiebt, sowie eine zweite Antriebseinrichtung (7,11), die die Druckeinrichtung antreibt und sie auf die Randeinrichtung in der Trennwand zu bewegt.

2. Verschlußsystem nach Anspruch 1, wobei die statischen Drücke der in den entsprechenden Räumen enthaltenen Flüssigkeiten so gesteuert werden, daß sie einander in der Tiefe der Öffnung, die in der Trennwand ausgebildet ist, annähernd gleich sind.

3. Verschlußsystem nach Anspruch 1, wobei die Druckeinrichtung aus einem Hebel (15), der sich um eine Drehwelle (14) dreht, sowie aus einem Antriebsmechanismus (7, 13, 12, 11, 16) zum Drehen des Hebels besteht.

4. Verschlußsystem nach Anspruch 1, wobei die Randeinrichtung der Öffnung eine bündige Kante aufweist, die parallel zur Trennwand ist.

5. Verschlußsystem nach Anspruch 1, das zum Waschen von Halbleiterplättchen eingesetzt wird, wobei die Öffnung ein geeignetes Maß für einen Durchgang für ein Halbleiterplättchen aufweist.

6. Verschlußsystem nach Anspruch 1, wobei die Abdichtfolie der Verschlußeinrichtung aus Polyether-Etherketon besteht.


## Revendications

1. Système d'obturateur comportant deux chambres ($S_1$, $S_2$) contenant des liquides (31, 32), une paroi de séparation (30) prévue entre les deux chambres, un dispositif d'obturation pour ouvrir et fermer une ouverture (20) pratiquée dans ladite paroi de séparation, ladite ouverture comportant un moyen de rebord (19) muni d'une arête affleurante, caractérisé par le fait que ledit dispositif d'obturation comprend un corps de châssis (21) et une feuille (23) faisant office de clapet réalisée en un film mince, maintenue par ledit corps de châssis parallèlement à ladite arête affleurante du moyen de rebord de ladite ouverture et conçue pour se déplacer transversalement à ladite arête affleurante et parallèlement à cette dernière, un moyen de presse (15) conçu pour presser la feuille faisant office de clapet contre l'arête affleurante du moyen de rebord de ladite ouverture, un premier moyen d'entraînement (6, 22) pour entraîner la feuille faisant office de clapet dans son déplacement transversal à ladite arête affleurante et parallèle à cette dernière, ainsi qu'un second moyen. d'entraînement (7, 11) pour entraîner le moyen de presse pour qu'il se déplace en direction du moyen de rebord de ladite ouverture pratiquée dans ladite paroi de séparation.

2. Système d'obturateur selon la revendication 1, dans lequel les pressions statiques des liquides contenus dans les chambres respectives sont réglées pour être approximativement égales l'une à l'autre à hauteur de ladite ouverture pratiquée dans ladite paroi de séparation.

3. Système d'obturateur selon la revendication 1, dans lequel ledit moyen de presse consiste en un levier (15) conçu pour tourner autour d'un arbre servant d'appui (14) et en un mécanisme d'entraînement (7, 13, 12, 11, 16) pour faire tourner ledit levier.

4. Système d'obturateur selon la revendication 1, dans lequel ledit moyen de rebord de ladite ouverture comporte une arête affleurante qui est parallèle à la paroi de séparation.

5. Système d'obturateur selon la revendication 1, utilisé pour laver des rondelles semi-conductrices, dans lequel ladite ouverture possède une dimension appropriée comme passage pour une rondelle semi-conductrice.

6. Système d'obturateur selon la revendication 1, dans lequel ladite feuille faisant office de clapet du dispositif d'obturateur est réalisée en polyéther-éther-cétone.

Fig.1

Fig. 2

# Fig.3

# Fig .4

# Fig . 5

EP 0 407 044 B1

# Fig · 6